Europäisches Patentamt

European Patent Office

Office européen des brevets

(19)

(11) Publication number: **0 046 408**
**A1**

## (12) EUROPEAN PATENT APPLICATION

(21) Application number: **81303767.8**

(22) Date of filing: **19.08.81**

(51) Int. Cl.³: **H 02 H 9/04**

(30) Priority: **20.08.80 US 179715**

(43) Date of publication of application: **24.02.82**
**Bulletin 82/8**

(84) Designated Contracting States: **AT BE CH DE FR GB IT LI LU NL SE**

(71) Applicant: **Power Integrity Corporation, 300 East Wendover Avenue, Greensboro North Carolina 27408 (US)**

(72) Inventor: **Hershfield, Walton Norman, 37 Golden Hind Passage, Corte Madera California 94925 (US)**

(74) Representative: **Wotherspoon, Graham et al, FITZPATRICKS 48 St. Vincent Street, Glasgow G2 5TT (GB)**

(54) Transient energy control and suppression circuit.

(57) Sinusoidal, direct current, or other power sources are maintained at or near their intended waveform even when attacked by transient voltage and current surges, and without the dissipation of electrical transient surge energy in the electrical devices served by the power sources. Toward this end, a surge suppression circuit is provided which utilizes a low pass filter positioned electrically upstream of a transient surge suppression device having a prescribed response time. The electrical components of the low pass filter and the transient surge suppression device are so matched that the peak voltage or current of the transient waveform will not rise past prescribed limits until after a time lapse greater than the response time of the transient surge suppression device. The transient waveform is thus modified in shape so that overshoot energy will be dissipated in the transient surge suppression device rather than being passed on to the electrical device served, thereby preventing damage and eliminating wasteful energy loss.

-1-
TRANSIENT ENERGY CONTROL
AND SUPPRESSION CIRCUIT

## Background of the Invention

The detrimental effect of transient voltage or current surges on electrical equipment of the type including semi-conductor devices therein is well known. A major cause of semi-conductor or insulation failure is electrical overstress. A well known phenomena is that when a power main or bus is inductive, switching that device can produce transient voltage and current surges. These perturbations on the power bus can damage electrical equipment or cause the device to malfunction. Connection of sensitive and electrically fragile integrated circuit and micro-electronic devices to these power sources have made voltage and current integrity even more critical. The speed of switching solid state devices is much greater than the equivalent mechanical switching relay or contactor. Switching of such high speed solid state devices increases the magnitude of the electrical transients because of the increase in the ratio of change in current (di) with changes in time (dt) as expressed in the equation $e = L (di/dt)$ where L is the inductance of the device being switched and e = the resultant voltage generated. Further, any deviation from constant voltage, direct current (DC) or a pure harmonic wave shape will create parasitic fields in the electronic devices being served which not only causes a useless consumption of energy but also substantially reduces the efficiency of the subject electrical device.

While certain non-linear voltage sensitive devices have been developed to control transient voltage, the speed of their response is often slower than the destruct time of the micro-electronic, integrated circuit or solid state devices in the equipment supposedly being protected. Tests show that transient pulses whose width are as small as 200 nanoseconds ($200 \times 10^{-9}$) is adequate to destroy or seriously damage sensitive electronic equipment, particularly equipment which

-2-

utilizes semi-conductor devices. As the internal dimensions of integrated circuits become smaller and part density per chip area increases, this destruct period will decrease from the 200 nanoseconds indicated above.

As a practical matter there is no protective device (transient surge suppression device) that operates instantaneously. All such devices require some time delay before being triggered. While the response time of several transient surge suppression devices theoretically offer protection under such short time spans as $200\text{x}10^{-9}$, normal circuit configuration and physical limitations make this difficult, if not impossible to achieve. As a practical matter, a micro-second ($10^{-6}$) is about the best response time achievable with known transient surge suppression devices which include gas discharge tubes, varistors, selenim rectifiers, zener diodes, and the like. Therefore, if the rise time of the transient to a damaging voltage level is less than the response time of the protective device, damage or destruction to sensitive electronic equipment will occur before any known protective devices can be triggered. Prior approaches to solving this problem have been directed toward developing suppression devices with faster response times, however, the instant invention approaches the problem in a different manner.

Summary of the Present Invention

The present invention, as opposed to prior approaches, is directed to a simple circuit that provides a delay in the originally fast rising wave front of the transient voltage. This modification slows the speed of the voltage surge to bring it within the range of the response time of the protective (non-linear transient voltage suppression) device. As a result, the transient surge suppressor is activated from its high resistant state to a conducting mode to dissipate the transient energy in the suppression device prior to the time the transient voltage surge has risen to a destructive level, so that destructive overshoot energy will no longer pass through the electrical equipment being protected. In order to delay the rise time of the transient voltage surge, a low pass filter is arranged electrically upstream of the selected transient surge suppression device and matched therewith so that the peak voltage of the transient wave form will not rise past the prescribed limits until after a time lapse greater than the response time of the corresponding transient surge suppression device. Other delay devices, such as piezoelectric devices, magnetostrictive filters, and the like might be used as alternatives to the low pass filter. Delay device, as used herein refers to any device that can cause transmission of one unit of information to be retarded until the action of another unit can be synchronized therewith.

In developing the invention, it is, first of all, important to point out that it is known that the impedence of an inductor is directly proportional to the frequency characteristics of an applied transient pulse whose sinusoidal component can be defined by Fourier's Integral Formula. Also, in the case of the impedance of a capacitance the inverse is true and is indirectly proportional to the frequency characteristics of the applied transient pulse. Therefore, if the transient voltage, before being presented to the transient surge suppression device, is processed through a properly matched combination of an inductive device and a capacitive element, arranged in what is commonly called a low-pass filter circuit, the wave form of the transient voltage will be modified such that the rise time across the capacitive element will be delayed or made greater. If the rise time achieved by the transient wave form modifying circuit can be matched to the trigger or response time of the transient surge suppressive device, so that the protective device triggers prior to the time the wave front exceeds prescribed limits, overshoot energy will no longer pass through the circuit; instead it will be dissipated in the transient surge suppression device. The "low-pass filter circuit" as defined in this application is a filter network which passes all

-4-

frequencies below a specified frequency with little or no loss, but attenuates strongly against higher frequencies. In conventional power mains, the specified frequency is 60 cycle Hz. LC circuits are typical types of low-pass filters, however, others are possible. The characteristics of the low-pass filter may be mathematically defined in a solution of the classic differential equation:

$$L\frac{di}{dt} + Ri + \frac{1}{C}\int i\ dt = e(t)$$

or its duality to define the relation between the inductive, capacitive, and/or resistive elements in the circuit. In general the response time of the non-linear electrical elements (transient surge suppressing device) to a safe limit dictates the selection of the values that will be defined in the above equation.

It is important to note that the low-pass filter network neither forces the overvoltage and overshoot energy into a second protective device (U.S. Patent No. 3,793,535 to Chowdhuri) nor does itself dissipate any energy. Its only function is to delay the rise time of the transient wave front, and is so matched with respect to the protective device, that the wave front transient does not exceed specified limits until after the protective device is triggered. There is thus provided an extremely simple, inexpensive approach to a problem which approach results in an effective elimination of damaging transient surges, not by attempting to earlier trigger a protective device, but by matching the components of the low-pass filter with the selected protective device.

It is therefore an object of the present invention to provide an inexpensive, effective suppression circuit.

Another object of the present invention is to provide a suppression circuit of the type described which effectively delays the rise time of the transient

-5-

wave front sufficiently that a protective device is triggered prior to the time the wave front exceeds critical limits.

Other objects and a fuller understanding of the invention will become apparent from reading the following detailed description of a preferred embodiment(s) along with the accompanying drawings in which:

Figure 1(a) is an electrical schematic of a typical LC type low-pass filter;

Figure 1(b) is an electrical schematic of a typical low-pass filter electrically connected upstream of a non-linear voltage sensitive unit;

Figure 2(a) graphically illustrates an electrical transient on a DC bus without filter or non-linear voltage suppression device;

Figure 2(b) graphically illustrates an electrical transient of Figure 2(a) after filter action;

Figure 2(c) graphically illustrates an electrical transient of Figure 2(a) after filter action and suppression by the non-linear voltage sensitive device;

Figure 3(a) graphically illustrates an electrical transient on an AC bus without filter or non-linear voltage suppression device;

Figure 3(b) graphically illustrates an electrical transient of Figure 3(a) after filter action;

Figure 3(c) graphically illustrates the electrical transient of Figure 3(a) after filter action and suppression by the non-linear voltage sensitive device;

Figure 4 is an electrical schematic of a typical L type suppressor module;

Figure 5 is an electrical schematic of a typical "Pi" suppressor module;

Figure 6 is an electrical schematic of a typical "T" suppressor module'

Figure 7 is an electrical schematic of a "twin Pi" suppressor module;

-6-

Figure 8 is an electrical schematic illustrating a suppressor module applied to a direct current power bus;

Figure 9 is an electrical schematic illustrating a suppressor applied to a single phase, two wire power bus;

Figure 10 is an electrical schematic illustrating a suppressor according to the present invention as applied to a single phase, three wire power bus;

Figure 11 is an electrical schematic illustrating suppressor modules according to the present invention applied to three-phase, three wire, delta power bus;

Figure 12 is an electrical schematic illustrating suppressor modules according to the present invention applied to three-phase, four wire Wye power bus;

Figure 13 is an electrical schematic illustrating a single phase or direct current suppressor module with fuse protection and an indicator lamp;

Figure 14 is a perspective view illustrating a single phase modular package for plug-in to a convenient receptacle;

Figure 15 is a perspective view illustrating a single phase or direct current module with screw terminal inputs/output connections;

Figure 16 is an electrical schematic illustrating suppressor modules according to the present invention as applied to three-phase, four wire, Wye power bus with fuse and monitor lamps attached; and

Figure 17 is a perspective view illustrating a typical package for a three-phase unit using three or six suppressor modules.

## Detailed Description of A Preferred Embodiment

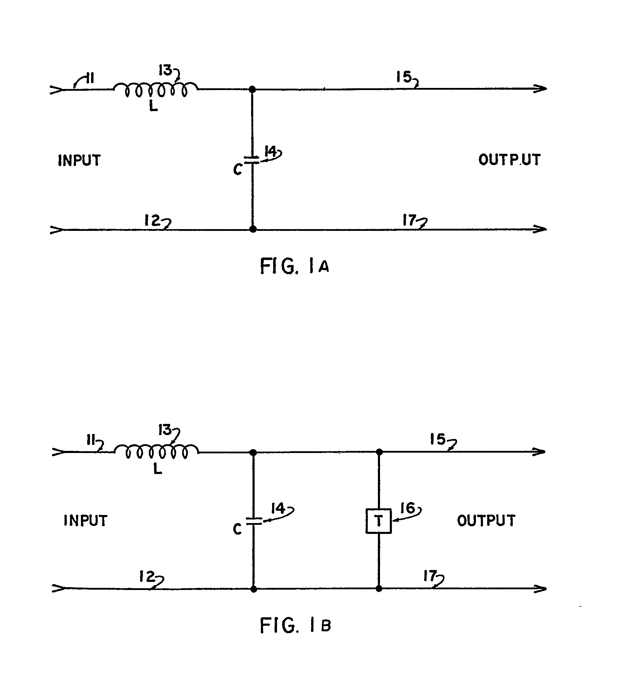

Turning now to the drawings and at the outset particularly to Figure 1(b), there is illustrated in the broadest sense the circuit which is the basis for the present invention. A transient voltage entering one wire 11 of the power main before being presented to

-7-

the transient surge suppression device 16, is processed through the combination of an inductive device 13 and a capacitive element 14 arranged in what is commonly called a low-pass filter circuit or configuration. In addition to the arrangement of components, the values of the components are so selected that the rise time of the transient waveform across the capacitive element 14 is matched to the trigger or response time of the transient surge suppression device 16, whereby overshoot energy will no longer pass to the device or load connected across outputs 15,17. Therefore, in accordance with the teachings of this invention, not only is the electrical arrangement of components important, but also the matching thereof.

It is well known that the impedence of an inductance varies directly and the impedance of a capacitance inversely with frequency when the voltage applied is sinusoidal in wave shape. Referring to Figure 1(a) input power is applied to the terminals 11,12. Voltage across the inductive device 13 is expressed by the differential equation $e=L(\frac{di}{dt})$ where e = instantaneous voltage; i = current; and t = time in volts, amperes, and seconds, respectively. The voltage across the capacitor 14 is expressed by the equation $e_c = \frac{1}{C} i_c \, dt$ where c is the capacitance in farads. The circuit illustrated in Figure 1(a) is one form of a "low-pass filter", however, the arrangement of Figure 1(a) more specifically is commonly referred to as an "L" type low-pass filter, and is illustrative only, as there are various other low-pass filters, as well as other delay devices (piezoelectric, magnetostrictive filters) which will also operate satisfactorily in this invention as will be illustrated hereinafter. One type of inductive device which has been found to function well as the inductive device is the ferrite bead, which is a cylindrical, tubular, ferrous based metallic member which is merely slipped onto a wire and secured at the proper place.

Referring to Figure 1(b) a non-linear voltage sensitive electrical device 16 has been added to the circuit of Figure 1(a). The non-linear voltage sensitive electrical device, also referred to as a transient surge suppression device, can assume many forms, such as a Zener diode, varistor, a voltage dependent resistor, gas discharge tube, clamping transistor, silicon control rectifier, triac, silicon suppressor such as the Trans Zorb, a registered trademark of General Semiconductor Industries, Inc., Tempe, Arizona or any one of a number of voltage sensitive devices are components in the circuit to provide the desired non-linear voltage characteristics. Preferably, however, the varistor serves the purpose very well.

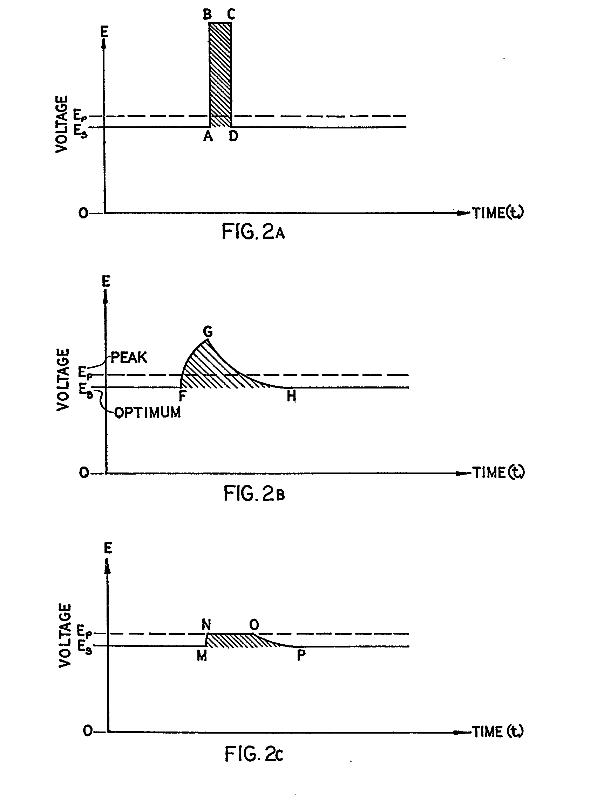

Turning now to Figure 2(a, b, c) there is illustrated three graphs with the abscissa in each case representing time t, and the ordinant representing voltage, E. In the case of DC voltages, this voltage could be 5 or 12 volts, which is a common operational voltage for integrated logic circuits, or it could be 12 or 24 volts as is used in automotive, aircraft, or other types of mobile equipment. Further, it could be the 24 or 48 volts DC commonly used for signalling and communication circuits such as telephone, fire alarm, burglar alarm, or similar systems. In Figure 2(a), there is illustrated a transient voltage of rectangular wave shape as defined by area A,B,C,D. The use of this rectangular shape is only illustrative as the transient wave form may be damped, critically damped or oscilliatory depending upon the electrical parameters of the device that generated the transient. This transient could have any source such as an associated unit of equipment in the circuit that is switched rapidly. If the rectangular pulse of Figure 2(a) is applied to terminals 11,12 of Figure 1(a) and the inductive device 13 and capacitive element 14 are properly selected, the resultant wave shape will be modified to the area F,G,H as illustrated in Figure 2(b). If the optimum supply

0046408

-9-

voltage is defined as $E_s$ and the peak supply voltage which is acceptable is defined as $E_p$, it can be seen that in both cases of Figure 1(a) and 1(b) the value of the voltage has exceeded $E_p$ in which case the energy of the transient voltage must be dissipated in the electrical devices that are served by the feed lines 11 and 12. If this voltage exceeds the withstand values for the connected devices they will either be damaged or cause to malfunction.

Referring to Figure 1(c) if the capacitor 14 is shunted by a suitably selected non-linear voltage dependent device 16 the non-linear device is triggered at voltage $E_p$; the wave form which passes on to the electrical equipment being protected is modified to that indicated as area MNOP in Figure 2(c). In this case the transient energy (area above line NO) has been dissipated in the non-linear device and not in the voltage sensitive devices connected to the output power bus terminal 15,12.

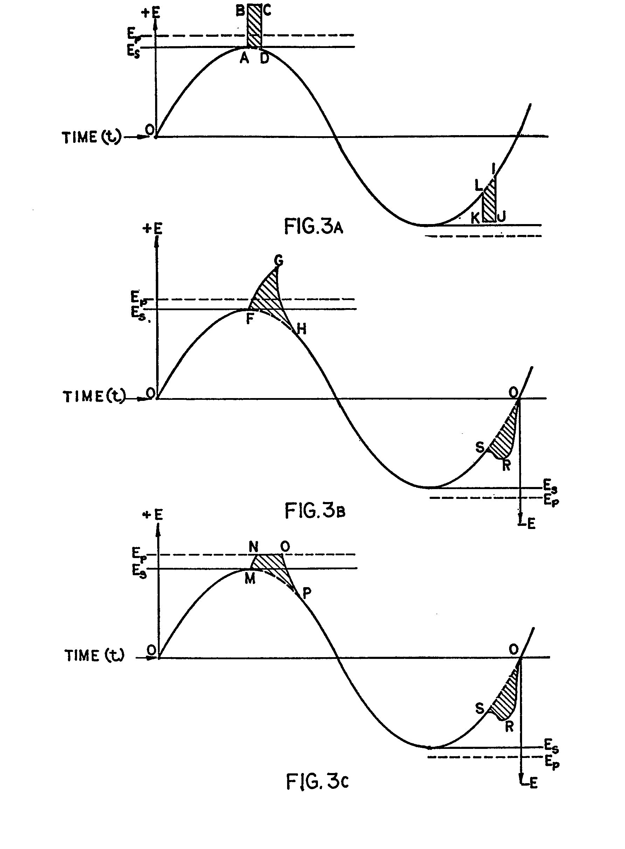

Turning now to Figure 3(a, b, c) there is illustrated the situation which occurs when a transient impulse is added to a sinusoidal wave form. A transient voltage can be developed at any time in the wave cycle, except when the current and voltage are zero. This transient voltage may be generated locally on the line by switching associated electrical equipment, or it may be externally generated in the power supply. While the supply wave form shown is sinusoidal, it may have other shapes such as the square or rectangular wave form of an inverter or the step waves commonly found in uninterruptable power supplies (UPS). A third family of waves are the rectangular waves created in pulse width modulation. In all cases the transient wave form is of short duration when compared with the period of the primary wave form delivering power to load. In Figure 3(a) the electrical transient ABCD is applied to the input terminals 11,12 of Figure 1(a). The action of the above described "L" type low-pass filter modifies the transient waveform to the wave shaped FGH indicated as the shaded area of Figure 3(b). If, however, the waveform is applied to a low-pass filter and the above described non-linear voltage sensitive device 16 shown in Figure 1(b), the waveform of the transient which passes on to the electrical device being served is modified to the form MNOP indicated in Figure 3(c). In Figure 3(a, b, c) the peak voltage of the normal waveform is indicated as Es. The nominal safe variation is indicated as Ep. In both cases of Figure 3(a) and (b) the transient voltage exceeds this safe level Ep and the transient energy is thus passed on to the electrical device being served. As was the case for the DC voltages of Figures 2(a, b, c), this excess energy may damage the affected equipment or cause it to malfunction. However, the addition of the non-linear device sensitive device 16 dissipates this overshoot energy and allows only safe levels of energy to pass to the equipment.

Referring again to Figure 3(a), a small transient IJKL is indicated. In this case the low-pass filter, as the name implies, modifies the wave form to that indicated as QRS in Figure 3(b) and (c). While the energy of the waveform QRS is not great enough to trigger and thus be absorbed by a transient suppression device, it is sufficiently altered that the period of the perturbation is increased and will be applied to the load at a slower time rate. It should be pointed out that unlike the non-linear voltage sensitive device 16 which is triggered at only one voltage level, the low-pass filter 13,14 is active at all voltage levels and within reasonable limits is active in all frequencies, particularly waveforms with harmonics many times the primary frequency or objectionable Radio Frequency (RFI) or Electromagnetic Interference (EMI).

While a pure inductance L and capacitance C do not exist in nature, many electrical devices, for reasons of efficiency have minimum resistance to absorb the energy of the electric transient when applied to the circuit. In the lossless circuit the electric transient

-11-

would continue to oscillate forever. For this reason the resistive characteristics of the non-linear voltage sensitive device also acts to reduce the oscillatory duration of the transient and accelerate the damping of the undesirable waveform.

Due to the high impedence of the inductive device L at high frequencies and correspondingly low impedence of the capacitor C, as the energy of the steep or high speed wave front of the electric transient is presented to the input terminals 11,12 of Figure 1(a) and (b), the output waveform is modified with the rise time considerably delayed to the output terminals 15,17 of the same figure. For this reason, with proper selection of components, the delayed rise time may be matched to the response time of the non-linear electric transient surge suppressor 16 of Figure 2(a). In Figures 2 and 3(a, b, c) this rise time modification is shown successively as AB, FG, and MN. In selecting components to match to the response time of the selected transient surge suppressor 16, characteristics of low-pass filters may be mathematically defined in a solution of the classic differential equation:

$$L\frac{di}{dt} + Ri + \frac{1}{C}\int idt = e(t)$$ where e = instantaneous voltage; t = time in seconds; i = current in amperes; L = inductance in henrys; C = capacitance in farads; and R = resistance in ohms; or its duality to define the relation between the inductive, capacitive, and/or resistive elements in the circuit. The response time of the non-linear electric transient surge suppressor 16 to a safe limit dictates the selection of the values of the components of the low-pass filter that will be defined in the above equation.

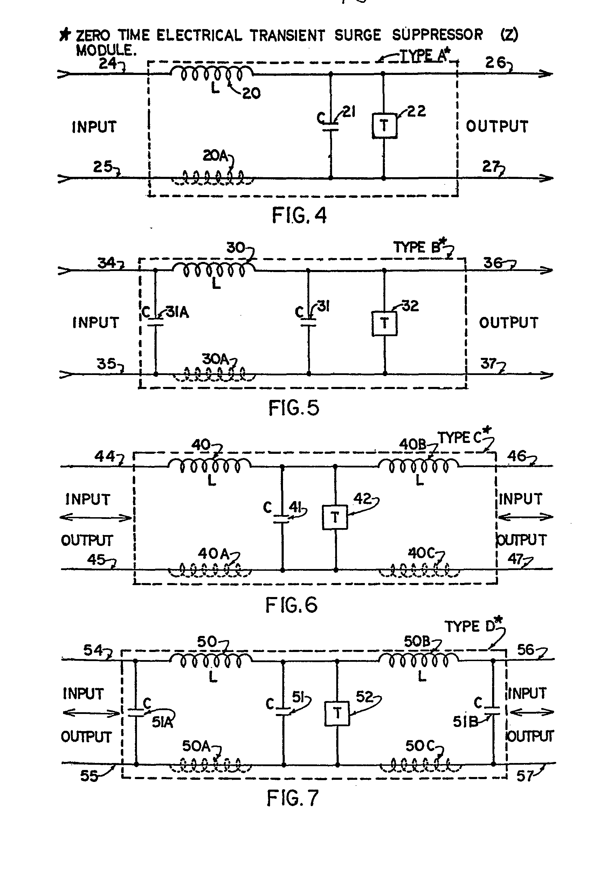

It is apparent from the information described hereinabove that this approach to "integrating" or delaying the input waveform can result in a number of configurations of "low-pass filter circuits". Four possible configurations are shown in Figures 4, 5, 6

-12-

and 7. This can be increased to eight circuits if the inductive devices indicated as dotted lines are added. However, in dealing with alternating current (AC) power mains where the ground integrity and minimum resistance are paramount, this scheme will find little use. Illustrating each of the four configurations:

A. Figure 4 is the "L" type low-pass filter also indicated in Figure 1. This approach may be modified by the addition of a second inductive device 20A inserted between ground bus terminals 25,27. As explained above, this device is a one-way unit with the filter-suppression unit taking place from inputs 24,25 to outputs 26,27.

B. In Figure 5 there is illustrated a "Pi" type low-pass filter, which is essentially a modification of the approach illustrated in Figure 4 with the addition of a second capacitor 31A upstream of the inductive device 30. This provides delaying energy storage activity at the input terminals 34,35 to further delay the rise time of the waveform when it is finally presented to the electric transient surge suppressor 32. Here again it must be noted that this unit is essentially a one-way device with the filtering and surge suppression action occuring in one direction from inputs 34,35 to outputs 36,37.

C. In Figure 6 there is illustrated a "T" type low-pass transient surge suppression combination that in essence provides similar electrical protection to conditions illustrated in Figure 4. However, this unit provides bilateral protection and would serve to prevent transfer of transient energy out of or into the load area. For example, the inductive device 40 and capacitor 41 prevents over-shoot energy from transients introduced at input terminal 44 from reaching the protective electrical device. Additionally, inductive devices 40B and capacitor 41 prevent overshoot energy from transient surges introduced at the load between terminals 46 and 47 from returning to the power main.

D. Figure 7 is a twin "Pi" filter suppression circuit that provides similar electrical characteristics and protection as indicated in Figure 5, however, this unit also provides bilateral action to prevent transfer of electrical transient energy into or out of the load.

Any one of the aforementioned circuits in Figures 4, 5, 6 and 7 will be hereinafter represented as "Z" (defining a "Zero Time Transient Surge Suppressor Unit") in the schematics that follow, indicating the wide application of such modules to control transient activity in commonly accepted power distribution networks.

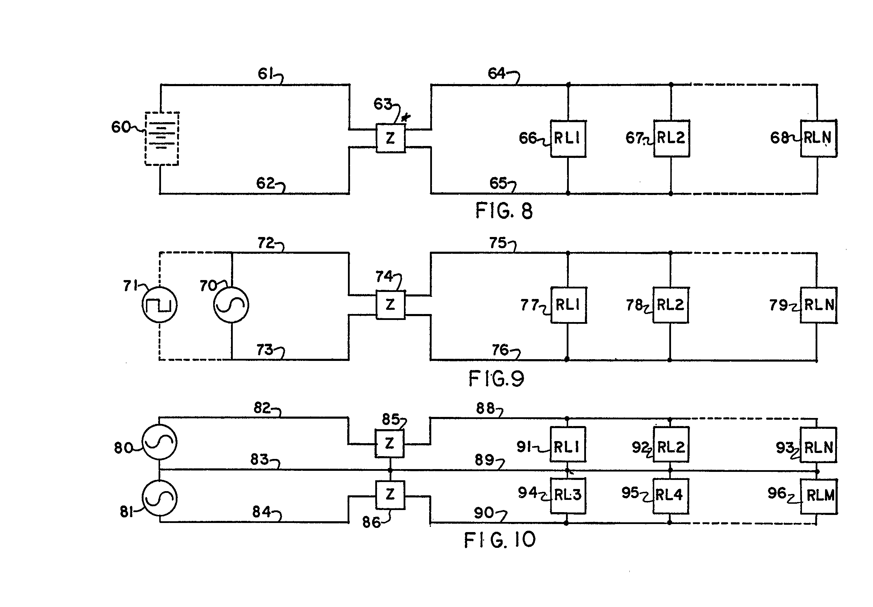

For example in Figure 8 there is illustrated a direct current (DC power) source 60 delivering power to loads 66,67, and 68 with the low-pass filter surge suppressor module 63 providing either unidirectional or bidirectional suppression action. Again in Figure 9, there is illustrated an AC power source 70, applied to power mains 72,73. This voltage may be sinusoidal, as indicated at 70, or some other waveform such as square as indicated at 71. Here again, the low-pass filter 74 is placed between loads 77,78 and 79 and the source voltage to provide either unidirectional or bidirectional suppression action.

In Figure 10 there is illustrated the single phase, three wire input 82,83,84 from electrical supplies 80 and 81, as might be used to serve a small residence or business. Through distribution busses 88,89,90 loads 91 through 96 are served. Transient surge suppression modules 85,86 are properly positioned between the power supply and the loads.

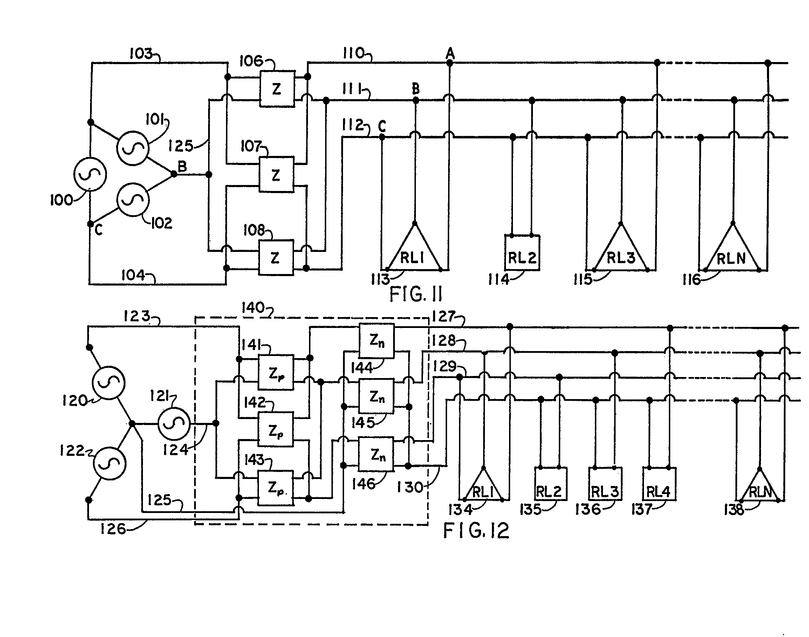

In Figure 11 there is illustrated the familiar "delta" three-phase power source 100,101,102 serving loads 113 through 116 through a three wire network

-14-

103,104,105, which, through suppressor modules 106,107 and 108, is isolated from the distribution bus 110,111,112. In this configuration it is apparent that in the absence of a common ground line, use of inductors in both sides of the line would be feasible as illustrated and the dotted line versions of Figures 4-7.

In Figure 12, the power source 120,121,122 is a three-phase, four wire, 123,124,125,126, Wye system. Six transient surge suppressant modules 141-146 are used. In the normal three-phase configuration the modules 144,145, and 146 are selected to clamp or suppress at 1.732 times $E_p$ value or some selected percentage above the phase-to-phase supply voltage. Here again inductors may be used in both legs of the suppressor module. However, they will seldom be used in both legs because of the desire to maintain the neutral lines at minimum impedence. The connected loads 134 through 138 may be either single or three phase as indicated, depending upon the system requirements. The combined filter-surge suppressors are indicated in one package, as shown by the dotted lines 140.

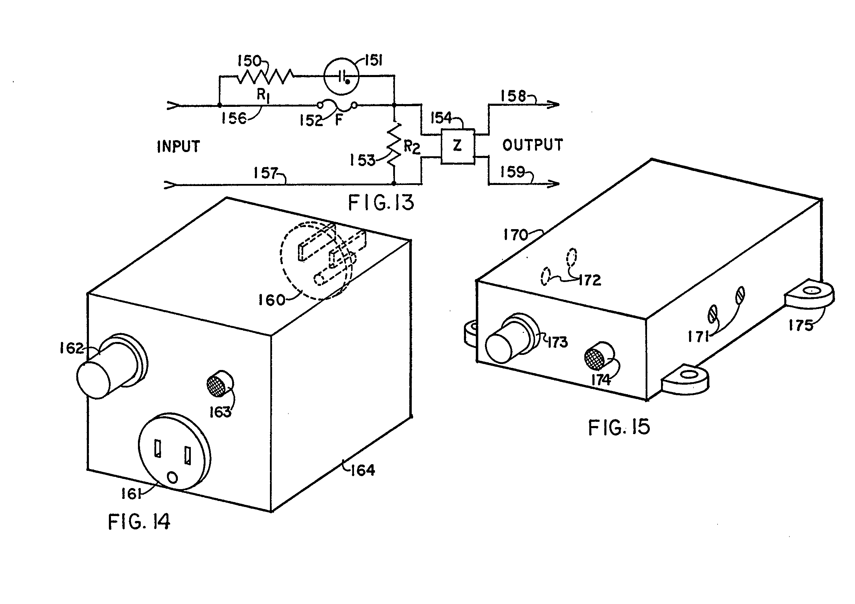

Figures 13,14 and 15 illustrate the practical application of the suppressor module approach. In the schematic of Figure 13, the neon monitor lamp is illustrated with the normal current limiting resistor 150. If short circuit conditions develop and fuse 152 is blown, the neon lamp 151 is no longer shorted by the low resistance of the fuse and through series resistors 150,153, the lamp reaches ignition voltage and turns on. This reminds the user that the unit is no longer serving the load connected to the output through the suppressor 154 to output bus 158,159. In Figure 14, there is illustrated the mechanical configuration of the circuit shown in Figure 13. A housing, either a plastic or metal case 164 includes an input socket 160. This unit serves the module housed inside the case. Fuse 162, pilot lamp 163 and power output receptacle

-15-

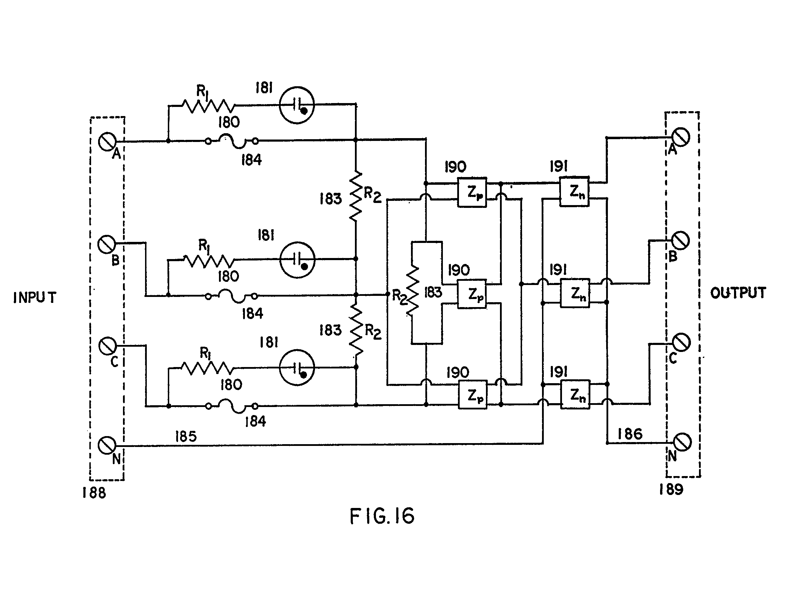

161 are shown on the rear of the enclosure. Figure 16
illustrates still another packaging configuration in
which the case 170 is mounted to an appropriate surface
using lugs 175. Input terminals 171 and output terminal
172 are either screw terminals, lugs, or wire leads.
The suppressor module is housed inside the case 170.
Related fuse and holder 173 and neon monitor lamp 174
are shown on the front surface of the housing 160.

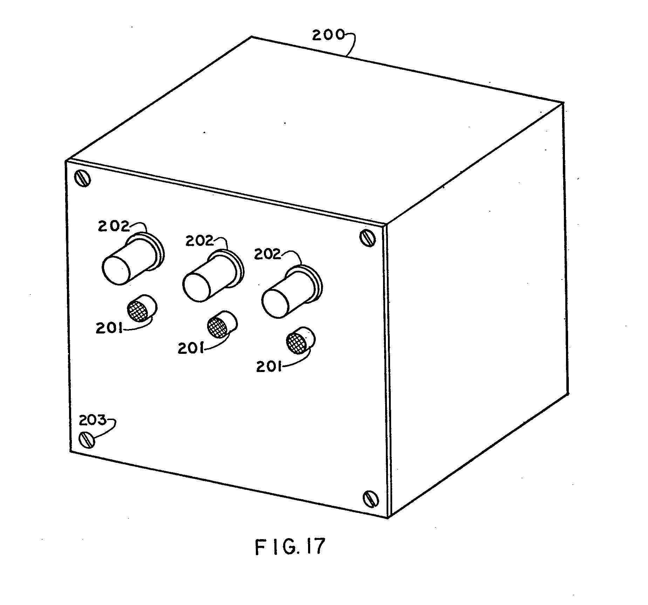

Figure 16 is illustrative of a practical application of the circuit whose operation was earlier defined
in Figure 12. In this particular circuit, there has
been added the neon lamps 181, with associated series
resistors 180 and 183. Should the fuse 184 be blown
due to either three-phase or single-phase overload, the
associated neon lamp is activated. Three-phase, four
wire, ABCN, input power is applied to input terminal
strip 188. Similarly, terminal strip 189 serves the
power output function. An appropriately sized, typical
package houses the three phase, four-wire system illustrated in Figure 17. The plastic or metal housing is
indicated at 200 with the screw cover 203. Fuses 202
and neon monitor lamps 201 are also illustrated.

While there has been shown and described particular
embodiments of the invention it should be apparent that
various modifications and further improvements can be
made herein without departing from the spirit and scope
of the invention as defined in the appended claims.

-16-

WHAT IS CLAIMED IS:

1. An electrical transient surge suppression circuit for protecting sensitive electronic devices and dissipating energy from transient surges of voltage and current irrespective of the rise time of electrical transient wave fronts which may pass therethrough, said circuit comprising:

    a) a transient surge suppression means having a prescribed trigger or response time shunted across the electronic device to be protected;

    b) a delay device positioned electrically upstream of said transient surge suppression means whereby electrical energy reaches said delay device prior to the time it reaches said transient surge suppression means;

    c) the electrical components of the delay device and the transient surge suppression means being so matched that the rise time of the transient wave front is delayed to such an extent that the peak voltage of the transient wave front will not rise past the prescribed limits until after a time lapse greater than said response time of the corresponding transient surge suppression means;

    d) whereby overshoot energy will be dissipated in the transient surge suppression means rather

-17-

than being passed on to the
protected electronic device.

2. The protective circuit according to Claim 1
wherein said delay device comprises a low-pass filter
means.

3. The protective circuit according to Claim 2
wherein said low-pass filter means comprises an inductive
device and a capacitive element arranged in an "L" type
low-pass filter.

4. The protective circuit according to Claim 2
wherein the value of the components of said low-pass
filter are related as defined by equation:

$$L\frac{di}{dt} + Ri + \frac{1}{C} + \int i \, dt = e(t)$$

where e = instantaneous voltage, (t) = time in seconds;
i = current in amperes, L = inductance in henrys; C =
capacitance in farads, and R = resistance in ohms.

5. The protective circuit of Claim 2 wherein
said low-pass filter means comprises an inductive
device and two capacitive elements arranged in a "Pi"
type low-pass filter.

6. The protective circuit of Claim 3 and further
including a second inductive device downstream of said
transient surge suppression means, wherein said low-
pass filter arrangement is defined as a "T" type low-
pass filter.

7. The protective circuit of Claim 2 and further
including a second inductive device and a second capacitive element downstream of said transient surge suppression means, said resulting low-pass filter arrangement
being defined as a "Twin-Pi" low-pass filter.

8. A method for preventing damaging transient
voltages and currents from bypassing a transient surge
suppression device prior to triggering of the suppression
device by retarding the fast rising wave front of the
transient in such a manner that the voltage of the
transient does not reach a critical level until such
time that the suppression device is triggered.

-18-

9. The method according to Claim 8 wherein said rise time is delayed by subjecting said transient to a low-pass filter prior to the time it is presented to the transient surge suppression device, and wherein the elements of said low-pass filter are selected according to the formula

$L\frac{di}{dt} + Ri + \frac{1}{C} + i\ dt = e(t)$ where e is the maximum allowable instantaneous voltage which is allowable; (t) is the use time to reach the prescribed voltage limit; L is the inductance of the inductive device of the low-pass filter in henrys; and C is the capacitance of the capacitive element in farads.

0046408

1/9

FIG. 1A

FIG. 1B

FIG. 2A

FIG. 2B

FIG. 2c

0046408

3/9

FIG.3A

FIG.3B

FIG.3c

✱ ZERO TIME ELECTRICAL TRANSIENT SURGE SUPPRESSOR (Z) MODULE.

FIG. 4

FIG.5

FIG.6

FIG.7

FIG. 8

FIG. 9

FIG. 10

FIG. 11

FIG. 12

INPUT

150 R₁

151

152 F

156

R₂

153

154 Z

158

159

157

OUTPUT

FIG.13

FIG.14

160

161

162

163

164

FIG.15

170

171

172

173

174

175

FIG.16

9/9

200

202

202

202

201

201

201

203

FIG.17

| DOCUMENTS CONSIDERED TO·BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | US - A - 4 156 838 (H.R. MONTAGUE)<br>* column 1, line 34 to column 2, line 15; line 35 to column 3, line 27; fig. 1* <br>—— | 1,2,8 | H 02 H    9/04 |
| | ELEKTRIE, Vol. 30, No. 7, 1976<br>P. FOCKE "Überspannungen in Nieder-spannungsnetzen und deren Bedämpfung in·leistungselektronischen Geräten"<br>pages 370 to 373<br>* page 371, fig. 2; page 373, paragraph 4, fig. 3; page 373; fig. 4 *<br>—— | 1-3,5 | |
| | F. MÖLLER et al. "Leitfaden der Elek-trotechnik" Vol. 1 Grundlagen der Elektrotechnik, 7th edition<br>1954, B.G. TEUBNER VERLAGSGESELLSCHAFT, Stuttgart, page 229<br>* page 229, formel 256a *<br>—— | 4,9 | TECHNICAL FIELDS SEARCHED (Int. Cl.³)<br><br>H 02 H    9/00<br>H 02 H    9/04<br>H 03 H    1/00<br>H 03 H    7/00<br>H 03 H    7/01<br>H 03 H    7/34 |
| | AT - B - 69 289 (ÖSTERREICHISCHE SIEMENS-SCHUCKERT-WERKE)<br>* claim 1; fig. 1 to 9 *<br>—— | 5-7 | CATEGORY OF CITED DOCUMENTS |
| D | US - A - 3 793 535 (P. CHOWDHURI)<br>* complete document *<br>——<br><br>./.. | 1-3 | X: particularly relevant<br>A: technological background<br>O: non-written disclosure  .<br>P: intermediate document<br>T: theory or principle underlying the invention<br>E: conflicting application<br>D: document cited in the application<br>L: citation for other reasons |
| | | | &: member of the same patent family, corresponding document |

X  The present search report has been drawn up for all claims

| Place of search | Date of completion of the search | Examiner |
|---|---|---|
| Berlin | 19-11-1981 | LEMMERICH |

European Patent Office

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| A | E. MEYER et al. "Schwingungslehre" 1974, F. VIEWEG + SOHN, Braunschweig pages 307 to 308, 347 to 349 * page 307, paragraph 4.2.1 to page 308, line 7, page 347, paragraph 4.4.2.1. to page 349, paragraph 4.4.2.2 * | 1-9 | |
| | ———— | | TECHNICAL FIELDS SEARCHED (Int. Cl.³) |

EPO Form 1503.2  06.78